(19) Europäisches Patentamt
European Patent Office
Office européen des brevets

(11) **EP 2 831 612 B1**

(12) **EUROPÄISCHE PATENTSCHRIFT**

(45) Veröffentlichungstag und Bekanntmachung des Hinweises auf die Patenterteilung:
**22.03.2023   Patentblatt 2023/12**

(21) Anmeldenummer: **13712149.7**

(22) Anmeldetag: **25.03.2013**

(51) Internationale Patentklassifikation (IPC):
**G01R 35/00** (2006.01)      **G01R 27/32** (2006.01)

(52) Gemeinsame Patentklassifikation (CPC):
**G01R 35/005; G01R 27/32**

(86) Internationale Anmeldenummer:
**PCT/EP2013/000899**

(87) Internationale Veröffentlichungsnummer:
**WO 2013/143681 (03.10.2013 Gazette 2013/40)**

(54) **VEKTORIELLER NETZWERKANALYSATOR**

VECTOR NETWORK ANALYSER

ANALYSEUR VECTORIEL DE RESEAU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.03.2012   DE 102012006195**

(43) Veröffentlichungstag der Anmeldung:
**04.02.2015   Patentblatt 2015/06**

(73) Patentinhaber: **Rosenberger Hochfrequenztechnik GmbH & Co. KG**
**83413 Fridolfing (DE)**

(72) Erfinder:
• **ENTSFELLNER, Christian**
**83413 Fridolfing (DE)**
• **HEUERMANN, Holger**
**52076 Aachen (DE)**

(74) Vertreter: **Zeitler Volpert Kandlbinder Patentanwälte Partnerschaft mbB**
**Werner-Eckert-Str. 4**
**81829 München (DE)**

(56) Entgegenhaltungen:
**EP-A2- 0 473 949     DE-A1-102007 020 073**

• **ANONYMOUS: "High-End-Netzwerkanalysator - zukunftsweisend und extrem schnell", Online , 2005, Seiten 26-31, XP002699987, Internet Gefunden im Internet: URL:http://www.rohde-schwarz.de/file/n188_zva_de.pdf [gefunden am 2013-07-01]**
• **Heuermann: "Untitled", , 2009, Seiten 5-33, XP002699988, Internet Gefunden im Internet: URL:http://www.heuermann.fh-aachen.de/files/download/diverse/coax.pdf [gefunden am 2013-07-01]**
• **Anonymous: "A network analyzer (150MHz)", , 15 November 2009 (2009-11-15), pages 1-36, XP055631917, Internet Retrieved from the Internet: URL:https://golac.fr/wpcontent/uploads/2009/11/ana_anglais_150mhz_3.pdf [retrieved on 2019-10-14]**

## Beschreibung

Die vorliegende Erfindung betrifft einen vektoriellen Netzwerkanalysator (VNA) mit mindestens einem Signalgenerator, welcher ein jeweiliges HF-Ausgangssignal erzeugt, und mit n Messtoren, wobei n eine ganze Zahl größer oder gleich eins ist, wobei jedem Messtor ein HF-Koppler derart zugeordnet und der HF-Koppler derart ausgebildet ist, dass der HF-Koppler ein in das jeweilige Tor von außen hinein laufendes HF-Signal $b_n$ auskoppelt, wobei der mindestens eine Signalgenerator derart angeordnet und ausgebildet ist, dass dieser ein jeweiliges HF-Ausgangssignal als nach außen auslaufendes HF-Signal $a_n$ mindestens einem Messtor zuführt, gemäß dem Oberbegriff des Anspruchs 1.

Seit vielen Jahren werden in der Elektronik bei tiefen Frequenzen (als LCR-Meter) und im Hochfrequenzbereich bis in den THz-Bereich wie auch dem optischen Bereich vektorielle Netzwerkanalysatoren (VNA) zur präzisen Vermessung von elektronischen linearen Bauteilen und Komponenten von aktiven und passiven Schaltungen bzw. Baugruppen eingesetzt. Ein VNA nimmt die Streuparameter von n-Toren (n = 1, 2, ...) auf, die ggf. in 2n-Pol-Parameter (z.B. Z- oder Y-Parameter) umgerechnet werden.

Insbesondere bei mittleren und hohen Frequenzen (schnellen Schaltungen, d.h. Schaltungen im MHz- und GHz-Bereich) weisen diese aufgenommenen Messdaten jedoch sehr große Messfehler auf. Heutzutage werden auch die Messfehler bei fast jedem NF-Gerät (LCR-Meter) mittels mathematischer Verfahren immens reduziert. Eine zugehörige Systemfehlerkorrektur der VNA sorgt dafür, dass präzise Messungen schneller elektronischer Bauteile, d.h. Bauteile im MHz- und GHz-Bereich, mit ausschließlich linearen Übertragungsverhalten überhaupt durchführbar sind.

Die Messgenauigkeit von VNA hängt in erster Linie von der Verfügbarkeit eines Verfahrens zur Systemfehlerkorrektur und den zugehörigen Kalibrierstandards ab. Bei der Systemfehlerkorrektur werden innerhalb des sog. Kalibriervorganges Messobjekte, die teilweise oder ganz bekannt sind, im Reflexions- und/oder Transmissionsverhalten vermessen. Aus diesen Messwerten erhält man über spezielle Rechenverfahren Korrekturdaten (sog. Fehlergrößen oder -koeffizienten). Mit diesen Korrekturdaten und einer entsprechenden Korrekturrechnung bekommt man für jedes beliebige Messobjekt Messwerte, die von Systemfehlern des VNA und der Zuleitungen (Verkopplungen = Übersprecher, Fehlanpassungen = Reflexionen) befreit sind.

Die in der Hochfrequenztechnik (HF-Technik) übliche Beschreibungsform des elektrischen Verhaltens von Komponenten und Schaltungen erfolgt über die Streuparameter (auch S-Parameter). Die Streuparameter verknüpfen nicht Ströme und Spannungen, sondern Wellengrößen miteinander. Diese Darstellung ist den physikalischen Gegebenheiten der HF-Technik besonders gut angepasst. Bei Bedarf können diese Streuparameter in andere elektrische Netzwerkparameter, die Ströme und Spannungen verknüpfen, umgerechnet werden.

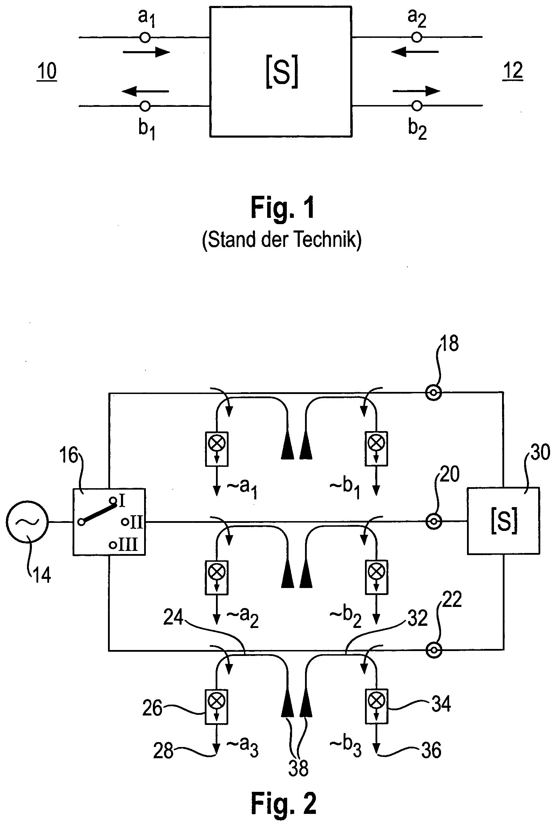

Fig. 1 zeigt ein Zweitor mit einem Tor 1 10 und einem Tor 2 12, das durch seine Streumatrix [S] gekennzeichnet sei. Die Wellen $a_1$ und $a_2$ seien die auf das Zweitor zulaufenden Wellen, $b_1$ und $b_2$ entsprechend die in umgekehrter Richtung sich fortpflanzenden Wellen. Es gilt die Beziehung:

$$\begin{pmatrix} b_1 \\ b_2 \end{pmatrix} = \begin{pmatrix} S_{11} & S_{12} \\ S_{21} & S_{22} \end{pmatrix} \begin{pmatrix} a_1 \\ a_2 \end{pmatrix}$$

Eine lineare Komponente ist durch diese S-Parameter, die über der Frequenz angegeben werden, ausreichend beschrieben. Bei einer Komponente, die nichtlineare Effekte aufweist, werden bei der Einspeisung eines Signals mit der Frequenz $f_0$ an einem Tor an den anderen Toren Signale mit dieser Grundfrequenz ($f_0$) und anderen Frequenzen erzeugt. Hierbei kann es sich z.B. um Oberwellen mit den Frequenzen $m*f_0$ (m = 2, 3, 4, ... ) oder beim Einsatz mehrerer Sendegeneratoren um Intermodulations- oder Mischprodukte handeln. Moduliert man einen der Sendegeneratoren, so ist die Anzahl der Frequenzen entsprechend groß.

Auch für diese nichtlinearen Komponenten können weiter die oben beschriebenen Streuparameter zur Beschreibung des Übertragungsverhaltens vorteilhaft verwendet werden. Jedoch gilt nun zu berücksichtigen, dass man nicht nur die Tore, sondern auch die Frequenzen mit angibt. So kann man zum Beispiel die vektorielle Streuparametergröße $S_{21}$ als Transmissionsübertragungsparameter mit dem Eingang Tor 1 10 bei der Grundwelle mit der Frequenz $f_0$ und dem Ausgang Tor 2 12 bei der Oberwelle mit der Frequenz $f_1 = 2*f_0$ einführen. Stand der Technik für diese Messungen sind überwiegend rein skalare Aufbauten. Einige vektorielle Netzwerkanalysatoren besitzen Software-Optionen, die organisatorisch die Messungen von Oberwellen, Intermodulationen, Mischprodukten und ähnlichen zulassen. Aber diese werden nur rein skalar und somit ohne Systemfehlerkorrektur durchgeführt.

Mit modernsten Netzwerkanalysatoren (ggf. unter Nutzung von zusätzlichen Soft- und Hardwarelösungen) misst man einschließlich einer Systemfehlerkorrektur diese nichtlinearen Übertragungseigenschaften von Bauelementen und Komponenten als vektorielle Größe. Diese vektoriellen Aussagen sind für das Modelling von Bauelementen, wie Transistoren, äußerst wichtig.

Als innovatives Systemfehlerkorrekturverfahren für diese nichtlineare Messungen auf vektoriellen Netzwerkanalysatoren ist aus US 2010/0204943 A1 "Without-Thru" bekannt. Dieses Systemfehlerkorrekturverfahren kommt ganz ohne Durchverbindungen (Without Thru) aus. Zum Kalibrieren werden neben den drei Reflexionsstandards Leerlauf, Kurzschluss und Abschluss (engl. Match oder Load) ein Leistungsmesskopf und ein Kammgenerator benötigt.

Als Stand der Technik werden all diese Systemfehlerkorrekturverfahren zur präzisen Bestimmung von linearen und nichtlinearen S-Parametern auf Netzwerkanalysatoren durchgeführt, die in der Mehrzahl 2*n Messstellen aufweisen, wobei n die Anzahl der Messtore repräsentiert. Diese Konstruktion ist in Fig. 2 angegeben. Ein HF-Synthesizer 14 gibt ein sinusförmiges Signal aus, das über einen Umschalter 16 jeweils einem Tor 1 18, einem Tor 2 20 und einem Tor 3 22 zugeführt wird. In der Schalterstellung III wird an einem ersten Leitungskoppler 24 ein Anteil des Signals ausgekoppelt und einer ersten Messstelle 26 zugeführt. Diese erste Messstelle 26 ist beispielsweise als ein A/D-Wandler ausgebildet. Bei höheren Frequenzen ist eine Mischstufe (nicht dargestellt) vor den A/D-Wandler geschaltet, die ein zusätzliches Lokaloszillatorsignal (LO-Signal) benötigt. An einem ersten Ausgang 28 wird ein Signal, das proportional zu einer herauslaufenden Welle $a_3$ ist, einer Auswerteeinheit, beispielsweise einem Computer, zugeführt. Der Großteil der am Tor 3 22 auslaufenden Welle läuft auf ein Messobjekt (MO) 30, wird dort ggf. reflektiert und ein reflektiertes Signal wird über einen zweiten Leitungskoppler 32 an einer zweiten Messstelle 34 gewandelt und über einen zweiten Ausgang 36 der Auswerteeinheit als reflektierte Welle $b_3$ zugeführt. Die anderen beiden Tore der ersten und zweiten Leitungskoppler 24, 32 sind jeweils mit einem 50 Ohm Abschluss 38 terminiert.

Diese Architektur nach Fig. 2 wird u.a. als Reflektometerkonzept bezeichnet. Die zahlreichen Kalibrierverfahren, die auf dem 7-Term-Fehlermodell beruhen, benötigen dieses Reflektometerkonzept.

In modernen Netzwerkanalysatoren wird der Umschalter 16 durch eine entsprechende Anordnung von HF-Synthesizern ersetzt. D.h. jedes Messtor 18, 20, 22 wird durch einen eigenen Synthesizer angesteuert.

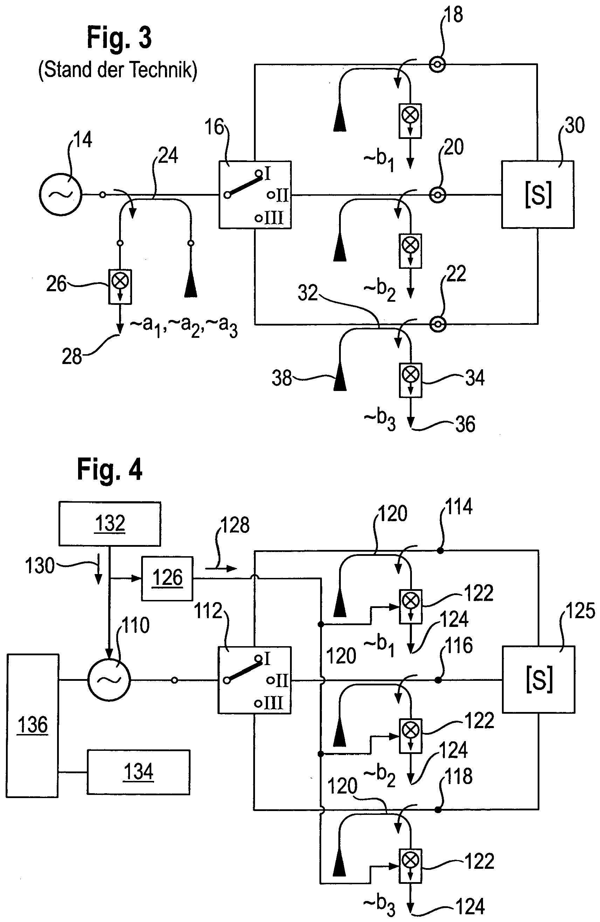

Eine im Hardware-Aufwand deutlich reduzierte Architektur ist in Fig. 3 dargestellt, wobei funktionsgleiche Teile mit gleichen Bezugszeichen wie in Fig. 2 bezeichnet sind, so dass zu deren Erläuterung auf die obige Beschreibung der Fig. 2 verwiesen wird. Im Unterschied zur Ausführungsform gemäß Fig. 2 ist der erste Leitungsrichtkoppler 24 stromauf des Schalters 16 angeordnet und die entsprechenden Leitungsrichtkoppler zwischen dem Schalter 16 und den jeweiligen Toren 18, 20, 22 entfallen. Der erste Leitungsrichtkoppler 24 detektiert somit die einlaufenden Signale $a_1$, $a_2$ und $a_3$. aus dem HF-Synthesizer 14. Bei diesem Konzept werden nur n+1 Messstellen benötigt. Nachteilig an diesem Konzept ist, dass hier nur ein Kalibrierverfahren eingesetzt werden kann. Als Zweitor-Messgerät handelt es sich um ein sogenanntes SOLT-Verfahren, dass auch als 12-Term-Verfahren bekannt ist. Als Mehrtorverfahren wurde es als GSOLT-Verfahren bezeichnet.

Preisgünstigste Zweitor-VNA arbeiten nur unidirektional, weisen somit keinen Umschalter 16 auf und messen dann nur noch die Vorwärtsparameter $S_{11}$ und $S_{21}$. Diese Geräte haben zwei Koppler und drei Messstellen. Die Empfangsmessstelle für $b_2$ benötigt keinen Koppler mehr.

Netzwerkanalysatoren weisen mit Abstand die größte Anzahl von Messstellen auf und sind folgerichtig die teuersten elektrischen Messgeräte. In der Produktionstechnik, in der man die preiswertesten VNA einsetzt, ist jede Vereinfachung der VNA willkommen, sofern die Messqualität erhalten bleibt und die Gerätekosten entsprechend sinken. Der fortgeschrittene Anwender von moderner Messtechnik möchte vektorielle Streuparameter nicht nur bei der Grundfrequenz sondern auch frequenzumsetzend mit einem möglichst geringen Kostenaufwand und möglichst in Echtzeit messen können. Bzgl. der Messzeit sind jedoch bekannte Lösungen für frequenzumsetzende Messungen unannehmbar langsam. Andererseits benötigen viele Messungen, wie z.B. die vektorielle PIM-Messung zur Ortung einer Fehlerstelle, nicht die Messgenauigkeit, die herkömmliche Verfahren bieten. Jedoch sollen diese Messungen schnell durchgeführt werden. Dies lässt sich jedoch nicht in der gewünschten Weise realisieren, da bei jeder Messung das Lokaloszillator-Signal (LO-Signal) mit vermessen werden muss. Weiterhin muss der LO-Generator mehrfach in der Frequenz verändert werden, damit die herauslaufenden, die reflektierten und die transmittierten Anteile detektiert werden können.

Die Druckschrift Anonymous: "High-End-Netzwerkanalysator - zukunftsweisend und extrem schnell", 2005, Seiten 26-31 offenbart einen Netzwerkanalysator R&S®ZVA mit hoher Messgeschwindigkeit und großem Dynamikbereich. Der Netzwerkanalysator R&S®ZVA weist 4 Messtore auf, die jeweils mit einem Messempfänger und einem Referenzempfänger ausgestattet sind. Je zwei Tore werden von einem Generator versorgt. Für die genaue Bestimmung der Amplitude und Phase des Generatorsignals ist der Referenzempfänger an jedem Messtor vorgesehen.

Die EP 0 473 949 A2 beschreibt einen Netzwerkanalysator zum frequenzselektiven Messen und Darstellen von frequenzabhängigen Messparametern. Hierbei ist ein interessierender Gesamtfrequenzbereich in mehrere unabhängig voneinander wählbare Teilbereiche unterteilt und je Teilbereich ist sowohl die Anzahl als auch die frequenzmäßige Verteilung der Frequenzschritte unabhängig von der Anzahl und der frequenzmäßigen Verteilung der Frequenzschritte der anderen Teilbereiche wählbar. Weiterhin ist je Teilbereich auch der Maßstab der Darstellung der Messparameter unabhängig von dem Maßstab der anderen Teilbereiche wählbar.

Die DE 10 2007 020073 A1 offenbart einen vektoriellen Netzwerkanalysator mit mehreren Messtoren. Jedem Tor kann das Messsignal mittels eines HF-Schalters zugeschaltet werden. Eine Wellentrennvorrichtung, typischerweise ein Richtkoppler, trennt die Wellen in ein dem Messtor zulaufende (FWD) und aus dem Messtor herauslaufende (REV) Hochfrequenzsignale. Diese Signale werden jeweils einem skalaren Detektor zur Amplitudenmessung zugeführt.

Die Druckschrift Heuermann: "Untitled", 2009, Seiten 5-33, Quelle: "URL:http://www.heuermann.fh-aachen.de/files/download/diverse/coax.pdf" offenbart die mit den Fig. 2 und 3 der vorliegenden Anmeldung beschriebenen vektoriellen Netzwerkanalysatoren nach dem Stand der Technik.

Die Druckschrift Anonymous: "A network analyzer (150MHz)", 15. November 2009 (2009-11-15, Seiten 1-36, XP055631917), Quelle: "URL:https://golac.fr/wpcontent/uploads/2009/11/ana anglais_150mhz 3.pdf" offenbart einen Netzwerkanalysator, bei welchem das Signal eines Signalgenerators vor dem zu vermessenden Objekt und nach dem Durchgang des zu vermessenden Objekts gemessen wird.

Der Erfindung liegt die Aufgabe zugrunde, einen vektoriellen Netzwerkanalysator der o.g. Art hinsichtlich des mechanischen und elektronischen Aufbaus sowie hinsichtlich der Bedienung und eines Messablaufes zu vereinfachen.

Diese Aufgabe wird erfindungsgemäß durch einen vektoriellen Netzwerkanalysator der o.g. Art mit den in Anspruch 1 gekennzeichneten Merkmalen gelöst. Vorteilhafte Ausgestaltungen der Erfindung sind in den weiteren Ansprüchen beschrieben.

Bei einem vektoriellen Netzwerkanalysator der o.g. Art ist es erfindungsgemäß vorgesehen, dass für das HF-Ausgangssignal für den mindestens einen Signalgenerator eine Amplitude und eine Phase in Abhängigkeit von mindestens einem Parameter in einem Parameterfeld in dem VNA abrufbar abgespeichert sind, wobei der mindestens eine Signalgenerator derart ausgebildet ist, dass er das HF-Ausgangssignal in Amplitude und Phase in Abhängigkeit von mindestens diesem einen Parameter reproduzierbar erzeugt.

Zum Messen der von einem Messobjekt weg in Richtung der Messtore laufenden HF-Signale $b_n$ ist jedem HF-Koppler eine Messstelle zugeordnet, die das jeweilige HF-Signal $b_n$ misst. Dabei weist jedes Messtor genau eine Messstelle auf.

Ein in der Amplitude und in der Phase reproduzierbares HF-Ausgangssignal erzielt man dadurch, dass der mindestens eine Signalgenerator eine Phasenregelschleife (PLL - Phase-Locked Loop) aufweist und an ein Referenzsignal gekoppelt ist.

Das Referenzsignal ist derart vorgesehen, dass dieses Signal einen Empfang von HF-Signalen $b_n$ an dem entsprechenden HF-Koppler triggert.

Dies hat den Vorteil, dass das aus dem jeweiligen n-ten Messtor auslaufende HF-Signal $a_n$ nicht separat gemessen werden muss, sondern aus dem Parameterfeld in einer gewünschten Genauigkeit entnommen werden kann. Hierdurch entfällt eine Messstelle für die Signale $a_n$ zum Bestimmen von Streuparametern. Es werden keine Referenzmessstellen mehr benötigt, wobei gleichzeitig die Kalibrierfähigkeit des Netzwerkanalysators nicht eingeschränkt ist. Dies ermöglicht mit sehr geringem Hardware- und Zeitaufwand die Messung von linearen und nichtlinearen Übertragungsgrößen nach Betrag und Phase. Somit ist insbesondere eine vektorielle und frequenzumsetzende Streuparametermessung für Mischer, Oberwellen oder Intermodulationen sehr schnell durchführbar. Dadurch, dass nur noch eine Messstelle pro Messtor benötigt wird, kann ein Netzwerkanalysator deutlich preiswerter und noch kompakter hergestellt werden.

Ein in Phase und Amplitude besonders gut reproduzierbares und stabiles HF-Ausgangssignal erzielt man dadurch, dass der mindestens eine Signalgenerator ein HF-Synthesizer ist.

Zum Bestimmen von Streuparametern im Frequenzraum ist der mindestens eine Parameter eine Frequenz des HF-Ausgangssignals. Weitere Parameter umfassen eine Ausgangsleistung des mindestens einen Signalgenerators, eine Umgebungstemperatur und/oder eine Messzeit pro Frequenzpunkt.

Eine besonders gute Reproduzierbarkeit von Sinussignalen an den Messtoren erzielt man dadurch, dass das Referenzsignal ein Quarz- oder ein Quarzoszillator-Signal (XCO-Signal), insbesondere mit der Frequenz 10 MHz, ist.

Einen besonders einfachen und kostengünstigen VNA mit gleichzeitig hoher Messgenauigkeit erzielt man dadurch, dass die Messstelle als A/D-Wandler ausgebildet ist.

Eine besonders gute und genaue Auskopplung eines HF-Signals erzielt man dadurch, dass mindestens ein HF-Koppler als Richtkoppler, insbesondere als Leitungskoppler, ausgebildet ist.

Bei einem Verfahren kann vorgesehen sein, dass mindestens eine in das Messobjekt hinein laufende, elektromagnetische Welle $a_n$ aus einem abgespeicherten Parameterfeld bestimmt wird, in dem Amplitude und/oder Phase für die von dem Signalgenerator erzeugte elektromagnetische Welle $a_n$ in Abhängigkeit von mindestens einem Parameter, welcher die Signalerzeugung des Signalgenerators beeinflusst, abgespeichert ist, wobei mindestens ein Parameter bestimmt und Amplitude und/oder Phase der von dem Signalgenerator erzeugten, elektromagnetischen Welle $a_n$ aus dem Parameterfeld für diesen mindestens einen Parameter entnommen wird.

Dies hat den Vorteil, dass das aus dem jeweiligen n-ten Messtor auslaufende HF-Signal $a_n$ nicht separat gemessen werden muss, sondern aus dem Parameterfeld in einer gewünschten Genauigkeit entnommen werden kann. Hierdurch entfällt eine Messstelle für die Signale $a_n$ zum Bestimmen von Streuparametern. Es werden keine Referenzmessstellen mehr benötigt, wobei gleichzeitig die Kalibrierfähigkeit des Netzwerkanalysators nicht eingeschränkt ist. Dies ermöglicht mit sehr geringem Hardware- und Zeitaufwand die Messung von linearen und nichtlinearen Übertragungsgrößen nach Betrag und Phase. Somit ist insbesondere eine vektorielle und frequenzumsetzende Streuparametermessung für Mischer, Oberwellen oder Intermodulationen sehr schnell durchführbar.

Ein in Phase und Amplitude besonders gut reproduzierbares und stabiles HF-Ausgangssignal erzielt man dadurch, dass als Signalgenerator ein HF-Synthesizer verwendet wird.

Zum Bestimmen von Streuparametern im Frequenzraum ist der mindestens eine Parameter eine Frequenz des HF-Ausgangssignals. Weitere Parameter umfassen eine Ausgangsleistung des Signalgenerators, eine Umgebungstemperatur und/oder eine Messzeit pro Frequenzpunkt.

Ein in der Amplitude und in der Phase reproduzierbares HF-Ausgangssignal erzielt man dadurch, dass mindestens ein Signalgenerator mit einer Phasenregelschleife (PLL - Phase-Locked Loop) an ein Referenzsignal, insbesondere ein Referenzsignal eines Quarzoszillators, gekoppelt ist.

Die Erfindung wird im Folgenden anhand der Zeichnung näher erläutert. Diese zeigt in:

Fig. 1    eine schematische Darstellung eines elektronischen Messobjektes in Form eines 2-Tores mit den Definitionen für die auf das Messobjekt zu und von dem Messobjekt weg laufenden elektromagnetischen Wellen $a_n$ und $b_n$;

Fig. 2    ein Blockschaltbild eines vektoriellen Dreitor-Netzwerkanalysators mit Umschalter und sechs Messstellen gemäß dem Stand der Technik;

Fig. 3    ein Blockschaltbild eines vektoriellen Dreitor-Netzwerkanalysators mit Umschalter und vier Messstellen gemäß dem Stand der Technik;

Fig. 4    ein Blockschaltbild einer bevorzugten Ausführungsform eines erfindungsgemäßen vektoriellen Netzwerkanalysators und

Fig. 5    ein Signalflussdiagramm von Fehlerkoeffizienten für ein "Tor1" des erfindungsgemäßen vektoriellen Netzwerkanalysators gemäß Fig. 4.

Die in Fig. 4 dargestellte, bevorzugte Ausführungsform eines erfindungsgemäßen Netzwerkanalysators weist einen Signalgenerator 110, einen Umschalter 112 und die drei Messtore "Tor 1" 114, "Tor 2" 116 sowie "Tor 3" 118 auf. Jedem Messtor 114, 116, 118 ist ein HF-Koppler 120 in Form eines Leitungskopplers zugeordnet, wobei jeder HF-Koppler 120 mit einer Messstellen 122 elektrisch verbunden ist. Die Messtore 114, 116 und 118 sind mit entsprechenden Toren eines elektronischen Messobjektes 125 verbunden, dessen Streuparameter (S-Parameter) bestimmt werden sollen. Dies ist beispielhaft mit einer Streumatrix [S] dargestellt, es können jedoch auch die Streuparameter einer Transmissionsmatrix oder eine Kettenmatrix bestimmt werden. Der Begriff "Streuparameter" soll hierin synonym für die Elemente einer beliebigen Matrix stehen, die elektrische Eigenschaften des elektronischen Messobjektes 125 hinsichtlich der zu- und weglaufenden Wellen $a_n$ und $b_n$ beschreibt bzw. diese Wellen $a_n$ und $b_n$ miteinander verknüpft. Die HF-Koppler 120 sind derart angeordnet, dass der HF-Koppler 120 des n-ten Tores die n-te von dem Messobjekt 125 weg in das jeweilige "Tor n" einlaufende Welle $b_n$ über die Messstelle 122 misst und an einem jeweiligen Ausgang 124 ausgibt, wobei n größer/gleich 1 ist und n kleiner/gleich N ist, wobei N die Anzahl der Messtore des vektoriellen Netzwerkanalysators angibt. In dem dargestellten Beispiel in Fig. 4 ist N gleich drei.

Der erfindungsgemäße vektorielle Netzwerkanalysator hat N Messstellen 122, d.h. dass nur noch N Messstellen 122 zur Vermessung eines N-Tores notwendig sind. Der Umschalter 112 ist beispielsweise durch eine entsprechende Anzahl (hier drei) von zuschaltbaren Synthesizern (nicht dargestellt) ausgebildet. Der Signalgenerator 110 ist beispielsweise als HF-Synthesizer ausgebildet und es ist mindestens ein Lokaloszillator (Mischoszillator) 126 vorgesehen. Der Lokaloszillator 126 gibt ein Mischoszillatorsignal $f_{LO}$ 128 an die Messstellen 122. Sowohl der Lokaloszillator 126 als auch der Signalgenerator 110 sind beispielsweise über eine PhasenRegelschleife (PLL - Phase-Locked Loop) an ein Referenzsignal $f_{ref}$ 130 eines Quarzoszillators 132 phasenstarr gekoppelt.

Der mindestens eine Signalgenerator 110 liefert ein in der Amplitude und der Phase bekanntes und reproduzierbares Signal $a_n$. Diese Eigenschaften (Amplitude und Phase) werden für die Messung von frequenzumsetzenden Streuparametern (S-Parametern) einmalig in Abhängigkeit von mindestens einem Parameter bestimmt und abrufbar in einem Parameterfeld 134 abgespeichert. Das Parameterfeld 134 der abgespeicherten Signale $a_n$ erstreckt sich über die Frequenz und ist optional über weitere Größen aufgespannt, wie einer Ausgangsleistung des Signalgenerators 110, einer Umgebungstemperatur T, einer Messzeit t pro Frequenzpunkt und weiteren. Mit anderen Worten sind die von dem Signalgenerator 110 erzeugten Signale $a_n$ in dem Parameterfeld 134 in Abhängigkeit von mindestens einem Parameter abgespeichert. Für eine gegebene bzw. bekannte Frequenz als beispielhaften Parameter kann man so aus dem Parameterfeld 134 die über das jeweilige "Tor n" zu dem Messobjekt 125 hin laufende Welle $a_n$ auslesen, ohne diese Welle $a_n$ mit einer zusätzlichen Messstelle messen zu müssen.

Eine Regelung der Ausgangsleistung (Amplitude) des Signalgenerators 110 ist durch eine Messeinheit (Leistungsdetektor) bewerkstelligt, die in einer Steuereinheit 136 angeordnet ist. Die feste Phasenanbindung des Signalgenerators 110 an das Mischoszillatorsignal $f_{LO}$ ist nur möglich, wenn das Teilerkonzept und die Phasenfrequenzregelung passend gewählt werden. So arbeiten moderne Konzepte mit SigmaDelta-Teilern, die Zufallsgeneratoren beinhalten. Solche Synthesizerarchitekturen sind für den erfindungsgemäßen VNA unbrauchbar. Das einfachste brauchbare Teilerkonzept für den erfindungsgemäßen VNA ist die klassische PLL-Konstruktion mit mehreren Schleifen und (einstellbaren) Festteilern.

Die Messstellen 122 sind beispielsweise als Analog/Digital-Wandler ausgebildet. Damit am erfindungsgemäßen VNA reproduzierbare Sinussignale an den Messstellen 122 anliegen, wird der Empfang der Analog/Digital-Wandler durch das Referenzsignal $f_{ref}$ 130 (auch Quarz- oder XCO-Signal genannt) von beispielsweise 10 MHz getriggert. Das Ausgangssignal des erfindungsgemäßen VNA ist richtig generiert, wenn es auf einem Oszilloskop, das durch das Referenzsignal $f_{ref}$ 130 des VNAs getriggert wird, für jeden Frequenzpunkt immer wieder gleich ist. Diese durch den speziellen Signalgenerator 110 erzeugte Eigenschaft macht aus einem Relativ-Messgerät (bisheriger VNA) ein Absolut-Messgerät (erfindungsgemäßer VNA). Bisher durften bei bekannten VNAs die Ausgangssignale von Messung zu Messung schwanken. Es musste immer nur das Verhältnis der beiden Wellengrößen eines Reflektometers reproduzierbar sein. Bei dem erfindungsgemäßen VNA müssen hingegen die Messwerte von der Kalibrierung bis zur Messung als Absolutwert reproduzierbar bleiben.

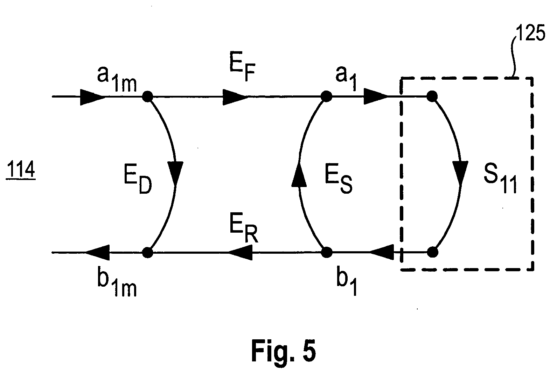

Der erfindungsgemäße VNA ist für den Einsatz für lineare Messungen geeignet, wie nachfolgend näher erläutert wird. Der erfindungsgemäße VNA genügt dem 7-Term-Modell und kann folglich alle VNA-Kalibrierverfahren unterstützen. Für einen Zweitorfall weist ein konventionelles Doppelreflektometer vier Messstellen auf. Beim erfindungsgemäßen VNA fehlen die beiden Referenzmessstellen. Jedoch muss zur Durchführung der Kalibrierverfahren ein Messwert für die Referenzmessstellen eingesetzt werden. Fig. 5 zeigt die Situation in Form eines Signalflussdiagramms der Fehlerkoeffizenten am Beispiel von "Tor 1" 114. $a_{1m}$ ist der Messwert der Referenzmessstelle, $a_1$ ist die reproduzierbare Welle am Messtor 1. $b_1$ ist die von dem Messobjekt 125 weg laufende Welle. $b_{1m}$ ist der Messwert an der Referenzmessstelle. $E_D$ ist ein Fehlerkoeffizient, der $a_{1m}$ und $b_{1m}$ miteinander verknüpft ($b_{1m}=E_D*a_{1m}$) und ein Übersprechen von $a_{1m}$ beschreibt. $E_F$ ist ein Fehlerkoeffizient, welcher $a_{1m}$ und $a_1$ miteinander verknüpft ($a_1=E_F*a_{1m}$). $E_R$ ist ein Fehlerkoeffizient, welcher $b_1$ und $b_{1m}$ miteinander verknüpft ($b_{1n}=E_R*b_1$). $E_S$ ist ein Fehlerkoeffizient, welcher $b_1$ mit $a_1$ miteinander verknüpft ($a_1=E_S*b_1$) und ein Übersprechen von $b_1$ beschreibt. $S_{11}$ ist ein Streuparameter der Streumatrix, welcher einen Eingangsreflexionsfaktor für das Messobjekt 125 bei angepasstem Ausgang des Messobjektes 125 beschreibt. Der Empfangswert $b_{1m}$ der einzigen Messstelle des erfindungsgemäßen VNAs weist einen Übersprecher von $a_{1m}$ auf. Hier kann die Näherung gemacht werden, dass $E_D$ null ist. In der Praxis ist $E_D$ mit Beträgen zwischen -35dB und -20dB gering. Diese Näherung erzeugt bei Reflexionsmessungen einen Fehler von einigen zehntel dB. Bei Transmissionsmessungen ist der Fehler kaum darstellbar. In diesem Fall reduzieren sich jedoch die Fehlerkoeffizienten und vereinfachte Kalibrierverfahren sind einsetzbar.

Für den allgemeinen Fall, dass $E_D$ ungleich null und $a_1$ reproduzierbar ist, kann ein beliebiger Wert (z.B. 1) für $a_{1m}$ eingesetzt werden. $E_F$ errechnet sich nur aus dem Verhältnis $a_1/a_{1m}$. $E_D$ errechnet sich bei der Kalibriermessung mit dem 50 Ohm Abschluss aus dem Verhältnis $b_{1m}/a_{1m}$.

Wenn $a_{1m}$ als ein beliebiger Wert (z.B. 1) festgelegt wird, dann entsprechen $E_D$ und $E_F$ keinen physikalischen Übertragungsgrößen. Dies ist in der Praxis auch nicht notwendig. Wird der erfindungsgemäße VNA nur für lineare Messungen eingesetzt, so muss man die Welle $a_1$ nicht kennen. Eine ggf. gegebene Einschränkung der Messgenauigkeit des Netzwerkanalysators hängt einzig von der Reproduzierbarkeit der Generatorsignale ab. Diese ist in der modernen HF-Elektronik jedoch bei richtiger Auslegung sehr hoch.

Der Erfindungsgemäße VNA ist auch für den Einsatz für nichtlineare Messungen geeignet, wie nachfolgend erläutert wird. Der erste große Unterschied für nichtlineare Messungen zum Stand der Technik ist die Tatsache, dass keine Messstelle für eine Kammgeneratormessung mehr notwendig ist. Die Hardware entspricht der des erfindungsgemäßen VNAs für lineare Messungen. Generell lässt sich jedes bekannte Kalibrierverfahren für frequenzumsetzende Messungen mit dem erfindungsgemäßen VNA unter der Festlegung der Messwerte der Referenzmessstellen auf einen festen Wert durchführen. Jedoch bietet die hohe Reproduzierbarkeit des Signalgenerators 110 neue Möglichkeiten. So muss der erfindungsgemäße VNA nur noch an Messadaptoren (vor den Messkabeln) einmalig komplett frequenzumsetzend kalibriert werden. Die Fehler der linearen Messkabel lassen sich aufgrund deren Reziprozität mit einem Standardkalibrierverfahren der linearen Messtechnik (z.B. MSO) individuell herauskalibrieren.

Die vorliegende Erfindung erlaubt unter dem Einsatz von nur einer Messstelle pro Messtor eine Realisierung eines VNAs, der lineare und nichtlineare Streuparameter (S-Parameter) messen kann. Somit ist es möglich durch Hardwarereduktion gegenüber dem Stand der Technik einen VNA zur Messung von linearen Komponenten als auch zur Messung von nichtlinearen Komponenten zu verwenden. Der Wegfall der Referenzmessstellen bedingt, dass weniger gemessen werden muss, was eine schnellere Messzeit mit sich bringt. Dieses wirkt sich insbesondere bei frequenzumsetzenden Messungen aus. Diese lassen sich mit dieser neuen Architektur (n-Messstellenkonzept) in Echtzeit durchführen. Der Hardwareaufwand für das lineare und das frequenzumsetzende Gerät sind im Wesentlichen identisch.

Das Prinzip der Netzwerkanalyse kann in vielen anderen Bereichen eingesetzt werden. Hierzu zählt u.a. die Radartechnik, die Füllstandsmessung und die Feuchtemessung. Diese aufgelisteten Messungen werden oft über Antennen im Freiraum durchgeführt. Eine Kalibrierung kann vor der Antenne oder im Freiraum erfolgen.

Durch die Reduktion des VNA-Hardwareaufwandes wird die Messgenauigkeit im Vergleich zu bekannten Lösungen verbessert. Beispielsweise weist ein aktuelles FMCW-Radar eine Messstelle auf und kann nicht wie ein VNA kalibriert werden. Mit der vorliegenden Erfindung weist ein Radar ebenfalls nur eine Messstelle auf. Hier können nunmehr die Übersprecher vom Sender zu der einen Messstelle herausgerechnet werden. Während ein FMCW-Radar nur den Realteil der Übertragungsfunktion misst, kann ein Radargerät mit der vorliegenden Erfindung die komplexe Übertragungsfunktion messen und weist somit eine deutlich größere Messgenauigkeit auf.

Bei einem Verfahren wird die Welle $a_1$ nicht mehr gemessen, sondern aus dem Parameterfeld 134 ausgelesen. Hierzu wird zunächst von der Steuereinheit 136 mindestens ein Parameter bestimmt, welcher Einfluss auf die Erzeugung der Welle $a_1$ durch den Signalgenerator 110 hat. Dies sind beispielsweise eine am Signalgenerator 110 eingestellte Frequenz und optional weitere Parameter, wie am Signalgenerator 110 eingestellte Ausgangsleistung und/oder Umgebungstemperatur T. Mit diesem oder diesen Parametern werden dann aus dem Parameterfeld 134 gewünschte Werte der Welle $a_1$ ausgelesen, wie die Amplitude und/oder Phase. In dem Parameterfeld 134 ist hierzu für jeden Wert des bzw. der Parameter eindeutig ein Wert für Amplitude und/oder Phase für die Welle $a_1$ hinterlegt. Diese Werte für Amplitude und/oder Phase für die Welle $a_1$ werden dann für die weitere Berechnung beispielsweise des Streuparameters $S_{11}$ der Streumatrix verwendet.

Das Parameterfeld 134 muss nur einmal für den Signalgenerator erzeugt werden. Hierzu werden einmalig die Werte für Amplitude und/oder Phase messtechnisch für verschiedene Werte mindestens eines Parameters bestimmt und in dem Parameterfeld 134 abgespeichert.

Bei frequenzumsetzenden Messungen, wie vektorielle PIM, wird der Netzwerkanalysator nur einmalig voll frequenzumsetzend kalibriert. Danach erfolgt nur noch eine Standardkalibrierung (wie MSO) zur Messkabelberechnung. Für frequenzumsetzende Messungen wird keine Messstelle für einen Phasenfehler des Lokaloszillators 126 mehr benötigt.

**Patentansprüche**

1.  Vektorieller Netzwerkanalysator (VNA) mit mindestens einem Signalgenerator (110), welcher ein jeweiliges HF-Ausgangssignal erzeugt, und mit n Messtoren, wobei n eine ganze Zahl größer oder gleich eins ist, wobei jedem Messtor ein HF-Koppler (120) derart zugeordnet und der HF-Koppler (120) derart ausgebildet ist, dass der HF-Koppler (120) ein von einem Messobjekt weg in Richtung des jeweiligen Messtors (114, 116, 118) von außen hinein laufendes HF-Signal $b_n$ auskoppelt, wobei der mindestens eine Signalgenerator (110) derart angeordnet und ausgebildet ist, dass dieser ein jeweiliges HF-Ausgangssignal als nach außen auslaufendes HF-Signal $a_n$ mindestens einem Messtor (114, 116, 118) zuführt,

wobei jedem HF-Koppler (120) eine Messstelle (122) zugeordnet ist, die das jeweilige HF-Signal $b_n$ misst, wobei jedes Messtor (114, 116, 118) genau eine Messstelle (122) aufweist, wobei für das HF-Ausgangssignal für den mindestens einen Signalgenerator (110) eine Amplitude und eine Phase in Abhängigkeit von mindestens einem Parameter in einem Parameterfeld (134) in dem VNA abrufbar abgespeichert sind, wobei der mindestens eine Signalgenerator (110) derart ausgebildet ist, dass er das HF-Ausgangssignal in Amplitude und Phase in Abhängigkeit von mindestens diesem einen Parameter reproduzierbar erzeugt, wobei der mindestens eine Signalgenerator (110) eine Phasenregelschleife (PLL - Phase-Locked Loop) aufweist und an ein Referenzsignal (130) gekoppelt ist, wobei das Referenzsignal (130) derart vorgesehen ist, dass dieses Signal (130) einen Empfang der in das jeweilige Messtor von außen hinein laufenden HF-Signalen $b_n$ an dem entsprechenden HF-Koppler (120) triggert.

2.  VNA nach Anspruch 1, **dadurch gekennzeichnet, dass** der mindestens eine Signalgenerator (110) ein HF-Synthesizer ist.

3.  VNA nach Anspruch 1 oder 2, **dadurch gekennzeichnet, dass** der mindestens eine Parameter eine Frequenz des HF-Ausgangssignals, eine Ausgangsleistung des mindestens einen Signalgenerators (110), eine Umgebungstemperatur und/oder eine Messzeit pro Frequenzpunkt ist.

4.  VNA nach mindestens einem der vorhergehenden Ansprüche, **dadurch gekennzeichnet, dass** das Referenzsignal (130) ein Quarz- oder ein Quarzoszillator-Signal (XCO-Signal), insbesondere mit der Frequenz 10 MHz, ist.

5.  VNA nach mindestens einem der vorhergehenden Ansprüche, **dadurch gekennzeichnet, dass** die Messstelle (122) als A/D-Wandler ausgebildet ist.

6.  VNA nach mindestens einem der vorhergehenden Ansprüche, **dadurch gekennzeichnet, dass** mindestens ein HF-Koppler (120) als Richtkoppler, insbesondere als Leitungskoppler, ausgebildet ist.

## Claims

1. Vector network analyzer (VNA) having at least one signal generator (110) which generates a respective RF output signal, and having n measurement ports, where n is an integer greater than or equal to one, each measurement port being assigned an RF coupler (120) and the RF coupler (120) being designed in such a way that the RF coupler (120) couples out an RF signal $b_n$ running away from a measurement object in the direction of the respective measurement port (114, 116, 118) from the outside, the at least one signal generator (110) being arranged and designed in such a way that it supplies a respective RF output signal as an outwardly outgoing RF signal at at least one measuring port (114, 116, 118), each RF coupler (120) being assigned a measuring point (122) which measures the respective RF signal $b_n$, each measuring port (114, 116, 118) having precisely one measuring point (122),

   wherein for the RF output signal for the at least one signal generator (110) an amplitude and a phase are stored in a parameter field (134) in the VNA in a retrievable manner as a function of at least one parameter, wherein the at least one signal generator (110) is designed in such a way that it reproducibly generates the RF output signal in amplitude and phase as a function of at least this one parameter,
   wherein the at least one signal generator (110) comprises a phase-locked loop (PLL) and is coupled to a reference signal (130), the reference signal (130) being provided such that this signal (130) triggers a reception of the RF signals $b_n$ running into the respective measurement port from outside at the corresponding RF coupler (120).

2. VNA according to claim 1, **characterized in that** the at least one signal generator (110) is an RF synthesizer.

3. VNA according to claim 1 or 2, **characterized in that** the at least one parameter is a frequency of the RF output signal, an output power of the at least one signal generator (110), an ambient temperature and/or a measurement time per frequency point.

4. VNA according to at least one of the preceding claims, **characterized in that** the reference signal (130) is a quartz signal or a quartz oscillator signal (XCO signal), in particular with the frequency 10 MHz.

5. VNA according to at least one of the preceding claims, **characterized in that** the measuring point (122) is designed as an A/D converter.

6. VNA according to at least one of the preceding claims, **characterized in that** at least one RF coupler (120) is designed as a directional coupler, in particular as a line coupler.

## Revendications

1. Analyseur de réseau vectoriel (VNA) avec au moins un générateur de signaux (110) qui génère un signal de sortie HF respectif, et avec n portes de mesure, n étant un nombre entier supérieur ou égal à un, un coupleur HF (120) étant associé à chaque porte de mesure et le coupleur HF (120) étant conçu de telle sorte que le coupleur HF (120) découple un signal HF $b_n$ entrant depuis l'extérieur en provenance d'un objet de mesure en direction de la porte de mesure respective (114, 116, 118),

   ledit au moins un générateur de signaux (110) étant disposé et conçu de telle sorte qu'il amène un signal de sortie HF respectif en tant que signal HF $a_n$ sortant vers l'extérieur à au moins une porte de mesure (114, 116, 118),
   un point de mesure (122) étant associé à chaque coupleur HF (120), lequel mesure le signal HF $b_n$ respectif, chaque porte de mesure (114, 116, 118) présentant exactement un point de mesure (122),
   une amplitude et une phase pour le signal de sortie HF dudit au moins un générateur de signaux (110) étant mémorisées dans le VNA de manière à pouvoir être appelées en fonction d'au moins un paramètre d'un champ de paramètres (134), ledit au moins un générateur de signaux (110) étant conçu de telle sorte qu'il génère le signal de sortie HF de manière reproductible en amplitude et en phase en fonction dudit au moins un paramètre,
   ledit au moins un générateur de signaux (110) présentant une boucle à verrouillage de phase (PLL - Phase-Locked Loop) et étant couplé à un signal de référence (130), le signal de référence (130) étant prévu de telle sorte que ce signal (130) déclenche une réception des signaux HF $b_n$ entrant dans la porte de mesure respective depuis l'extérieur sur le coupleur HF (120) correspondant.

2. VNA selon la revendication 1, **caractérisé en ce que** ledit au moins un générateur de signaux (110) est un synthétiseur HF.

3. VNA selon la revendication 1 ou 2, **caractérisé en ce que** ledit au moins un paramètre est une fréquence du signal de sortie HF, une puissance de sortie dudit au moins un générateur de signaux (110), une température ambiante et/ou un temps de mesure par point de fréquence.

4. VNA selon au moins l'une des revendications précédentes, **caractérisé en ce que** le signal de référence (130) est un signal de quartz ou d'oscillateur à quartz (signal XCO), en particulier de fréquence 10 MHz.

5. VNA selon au moins l'une des revendications précédentes, **caractérisé en ce que** le point de mesure (122) est conçu comme un convertisseur A/N.

6. VNA selon au moins l'une des revendications précédentes, **caractérisé en ce qu'**au moins un coupleur HF (120) est conçu comme un coupleur directionnel, en particulier comme un coupleur de ligne.

**Fig. 1**

(Stand der Technik)

**Fig. 2**

## Fig. 3
(Stand der Technik)

## Fig. 4

**Fig. 5**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100204943 A1
- EP 0473949 A2
- DE 102007020073 A1

**In der Beschreibung aufgeführte Nicht-Patentliteratur**

- **ANONYMOUS.** *High-End-Netzwerkanalysator - zukunftsweisend und extrem schnell,* 2005, 26-31
- **HEUERMANN.** *Untitled,* 2009, 5-33, URL:http://www.heuermann.fh-aachen.de/files/download/diverse/coax.pdf
- **ANONYMOUS.** *A network analyzer (150MHz),* 15. November 2009, 1-36, URL:https://golac.fr/wpcontent/uploads/2009/11/ana anglais_150mhz 3.pdf